# EUROPÄISCHE PATENTANMELDUNG

(11) **EP 2 542 039 A1**
(43) Veröffentlichungstag der Anmeldung: **02.01.2013**
(21) Anmeldenummer: 12003020.0
(22) Anmeldetag: 30.04.2012
(51) Int. Cl.: H05K 3/12, B29C 67/00

(54) **Verfahren zum Herstellen von elektrischen und elektronischen Funktionen auf einem Substrat sowie Bauteil**

(30) Priorität: 27.06.2011 DE 102011105596
(71) Anmelder: Bauer, Jörg R., 88250 Weingarten (DE)
(72) Erfinder: Bauer, Jörg R., 88250 Weingarten (DE)

(57) **Zusammenfassung**

Verfahren zum Herstellen von elektrischen,- elektronischen Funktionen auf einem Substrat, sowie nach dem Verfahren hergestelltes Bauteil, wobei die geometrische Abmessung einer Trennschicht funktionsbezogen der geometrischen Abmessung einer Funktionsschicht zugeordnet ist, und stufenförmige angeordnete Kontaktflächen (34) der sich überlagernden Funktionsschichten so gebildet werden, indem jeweils in den der Funktionsschicht überlagernden Schichtbereichen eine Aussparung in der geometrischen Abmessung erfolgt. Digital gesteuerte, aushärtbare Flüssigkeitströpfchen (54) werden zur Bildung einer leitfähigen Funktionsschicht volumenbildend so aufgebracht, dass zumindest zwischen zwei Funktionsschichten, aus unterschiedlichen Schichtbereichen, eine leitfähige Verbindung gebildet wird.

## Beschreibung

Die Erfindung betrifft ein Verfahren zum Aufbringen von leitfähigen und nichtleitfähigen Schichtbereichen auf eine Fläche oder Körper. Durch die Anordnung der Kontaktflächen der unterschiedlichen Funktionsschichten lassen sich mittels digital gesteuerter, leitfähiger, aushärtbarer Flüssigkeitströpfchen leitende Verbindungen der unterschiedlichen Schichtbereiche herstellen.

Bekannt ist, dass bei der Herstellung einer Leiterplatte die Basis für das Aufbringen von Leiterbahnen und elektrischen,- elektronischen Bauteilen eine feste Basisträgerplatte z.B. Kunststoff oder Keramik die Basis bildet. So eine Trägerplatte kann beidseitig bestückt werden. Eine Kontaktverbindung der auf den beiden voneinander abgewandten Seiten erfolgt, indem die Platte eine Öffnung aufweist in der ein leitfähiges Verbindungselement eingebracht ist, das zu den Leiterbahnen auf beiden Seiten eine Kontaktverbindung bildet, z.B. mittels einer Metallhülse die auf beiden Seiten umgebördelt wird. Diese Leiterplatten sind vorgefertigte Baugruppen die durch Steckverbindungen eine Schnellmontage zur Fertigung ermöglichen. So ist auch bekannt, dass Leiterbahnen mittels digitaler Druckverfahren hergestellt werden, wobei Flüssigkeiten mit leitfähigen Substanzen elektronisch gesteuert abgegeben werden und nach ihrer Trocknung eine Leiterbahn bilden.

**Die Aufgabenstellung** ergibt sich dadurch, dass eine Möglichkeit geschaffen wird Leiterplatten, Platinen oder elektrische,- elektronische Bauruppen die aus mehreren Schichtlagen aufgebaut sind, kostengünstiger, mit verkürzten Produktionszeiten und spezifischeren Funktionsanforderung auch in kleinen Losgrößen bei 0-Lagerhaltung herzustellen.

Der Erfindung liegt die Aufgabe zu Grunde, eine Möglichkeit zu schaffen, Funktionsschichten, die mit leitfähigen Substanzen in flüssiger Form mittels elektronisch gesteuerter Druckköpfe in Tröpfchen auf eine Oberfläche abgegeben werden und dort härten, in mehreren Schichtlagen übereinander aufzubringen.

Die mit der Erfindung erzielten Vorteile bestehen insbesondere darin, dass Kontaktstellen in beliebiger Zuordnung untereinander zu den sich überlagernden Funktionsschichten hergestellt werden können, was zu dem wesentlichen Vorteil führt, dass elektrische,-elektronische Funktionen mit in sich überlagernden Schichtbereichen direkt ohne eine Trägerplatte auf die Oberfläche eines Körpers oder Bauteiles aufgebracht werden können.

Eine Lösung dieses Problems wird mit dem Verfahren gemäß dem Anspruch 1 gelöst.

Die Unteransprüche 2 bis 10 sind auf vorteilhafte Durchführungsformen des erfindungsgemäßen Verfahrens gerichtet.

Der Anspruch 11 ist auf ein nach dem Verfahren hergestelltes Bauteil gerichtet.

Die Erfindung, die für unterschiedlichste Anwendungen eingesetzt werden kann, wird im Folgenden anhand schematischer Zeichnungen beispielsweise und mit weiteren Einzelheiten erläutert.

### Die Figuren stellen dar:

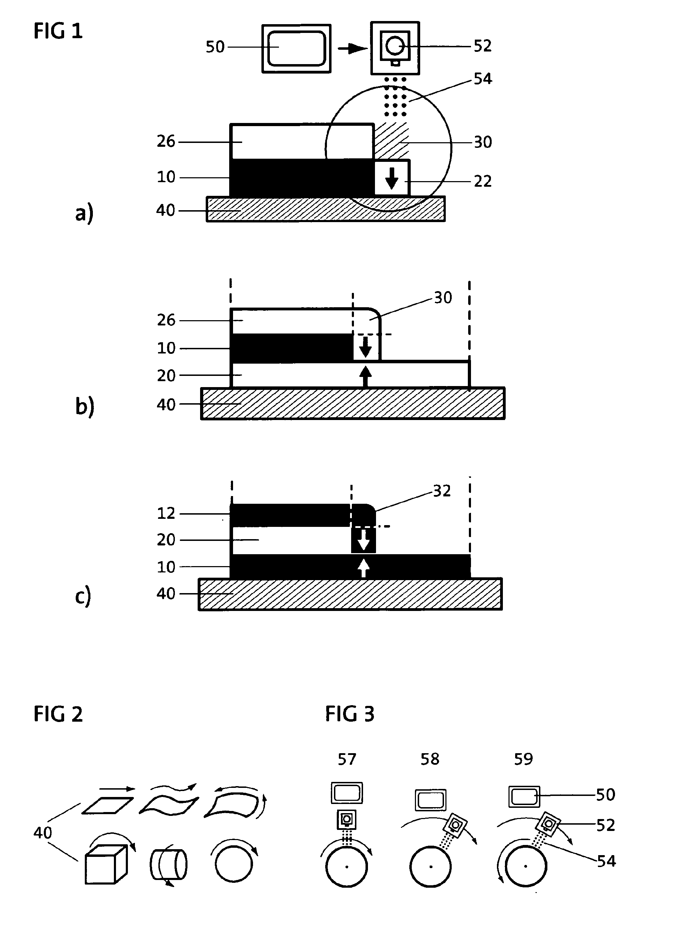

Figur 1/a einen Querschnitt zweier sich überlagernder Schichtbereiche ohne einen Volumenausgleich.
Figur 1/b einen Querschnitt sich überlagernder Schichtbereiche wobei in der Deckschicht ein volumenbildender Schichtbereich ausgebildet ist.
Figur 1/c einen Querschnitt sich überlagernder Schichtbereiche wobei in der Funktionsschicht ein volumenbildender Schichtbereich ausgebildet ist.
Figur 2 Darstellungen von Substraten in Form von Flächen und Körpern.
Figur 3 Darstellungen von Ausführungsformen von Anlagen zum Aufbringen von Flüssigkeitströpfchen auf Substrate.
Figur 4 einen Querschnitt von Ausführungsformen von Funktionsschichten auf Substraten.
Figur 5/a einen Querschnitt von sich überlagernden Schichtbereichen und einer aufzubringenden Deckschicht.

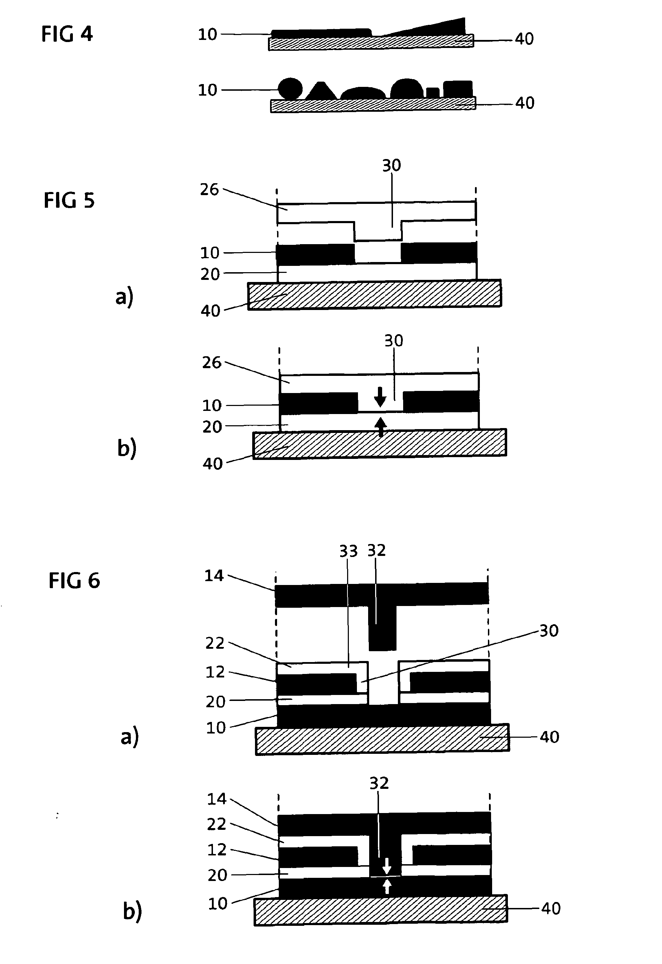

Figur 5/b einen Querschnitt sich überlagernder Schichtbereichen wobei in der überlagernden Deckschicht ein volumenbildender Schichtbereich ausgebildet ist.
Figur 6/a einen Querschnitt von gestuften sich überlagernden Schichtbereichen und einer aufzubringenden Funktionsschicht.
Figur 6/b einen Querschnitt von gestuften, sich überlagernden Schichtbereichen wobei in der überlagernden Funktionsschicht ein volumenbildender Schichtbereich ausgebildet ist.

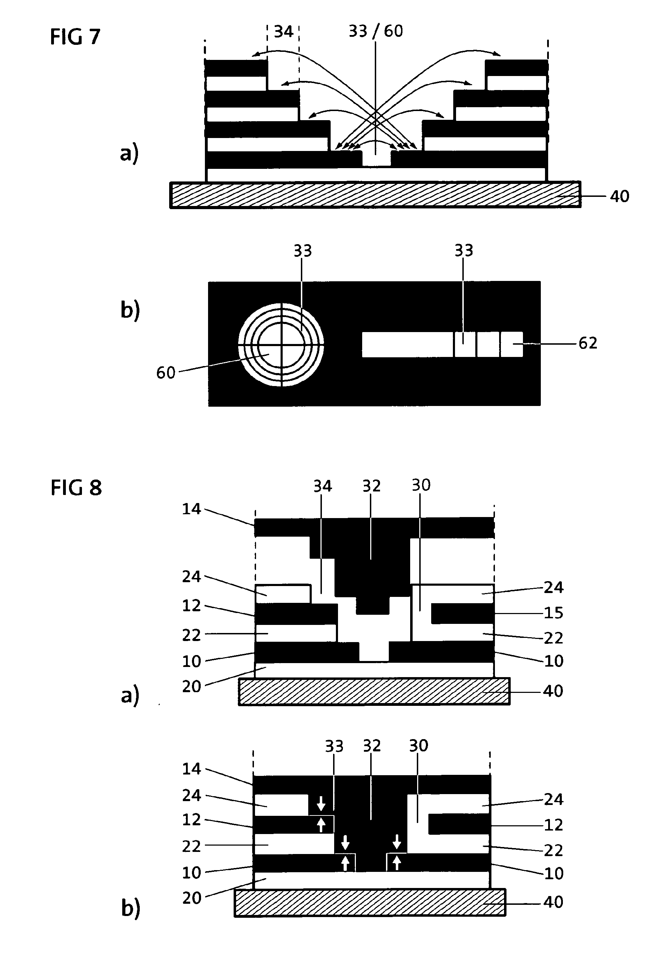

Figur 7/a einen Querschnitt von kegelförmig gestuften, mehrfach überlagernden Schichtbereichen
Figur 7/b eine Aufsicht von zwei Ausführungsformen von Stufen-Korridoren zur Bildung von Kontaktflächen.
Figur 8/a einen Querschnitt von kegelförmig gestuften, überlagernden Schichtbereichen und einer aufzubringenden Funktionsschicht.
Figur 8/b einen Querschnitt kegelförmig gestuften überlagernden Schichtbereichen wobei in einzelnen Schichtbereichen ein volumenbildender Schichtbereich ausgebildet ist.

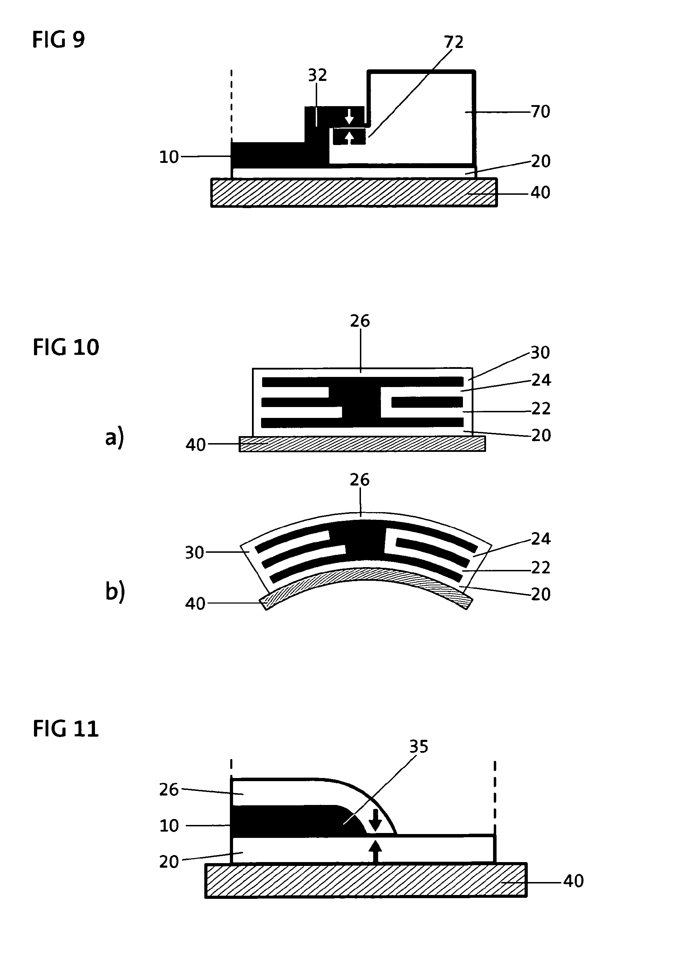

Figur 9 einen Querschnitt von einer kontaktbildenden Funktionsschicht mit einem Elektro,- Elektronikmodul.
Figur 10/a einen Querschnitt einer Kapselbildung von gestuften und volumenbildenden Schichtbereichen.
Figur 10/b einen Querschnitt einer elastisch verformbaren Kapselbildung von gestuften und volumenbildenden Schichtbereichen.
Figur 11 einen Querschnitt von sich überlagernden Schichtbereichen wobei in der Funktionsschicht ein volumenreduzierter Schichtbereich ausgebildet ist.

Das Verfahren findet bevorzugt Anwendung bei der Herstellung sich überlagernden und kontaktierenden Funktionsschichten mittels Digitaldruckprozess, wie beispielsweise zur Herstellung von Sensoren, Schaltungen, Schaltkreise oder Leiterbahnen, die auf Trägerschichten oder direkt auf Bauteile aufgebracht werden.

Geeignete Substrate (40) zum Aufbringen der überlagernden Schichtbereiche sind:
- feste, biegefähige und/oder elastische Kunststoffe in Form von Platten oder Folien (wie beispielsweise PS, PE, PP, PET, Acryl, Harze),
- durch Stanzung, Zieh- oder Spritzverfahren geformte Kunsstoffteile
- Metalle, beispielsweise in Blechform, als Stanzteile, Teil durch Umformtechnik oder Druckgussverfahren
- Papier, Karton (Papiere mit Anteilen an Füllstoffen, Farbstoffen und/oder Kunststoffen)
- Keramik
- Glas
- Holz und Holzwerkstoffe
- oder Substrate (40) die aus Materialkombinationen bestehen.

Eine erfindungsgemäße Anwendungsform wird geschaffen wenn ein biegefähiges und/oder elastisches Substrat (40) mit zusätzlich einer Selbstklebeschicht ergänzt wird. Hiermit wird die Möglichkeit geschaffen, dass ein biegefähiges, aus mehreren Schichten gebildetes Bauteil beispielsweise mit 0.05 -2 mm Dicke, an beliebiger Stelle und sofort funktionsfähig aufbringbar ist.
Eine Ausführungsform des Substrates (40) kann als Endlosband ausgebildet sein. Definierte Abschnittsbereiche können darüberhinaus mit Funktionen belegt und abtrennbar sein.

Im Ink-Jet Druckverfahren sind Schichtbreiten und Schichtstärken ab ca. 5 Mikrometer und größer aufbringbar. Für vermehrte Anwendungen werden Schichtstärken bei 10 - 200 Mikrometer eingesetzt.

Eine Funktionsschicht wird durch eine Flüssigkeit gebildet, die vorbestimmte physikalische Eigenschaften hat, beispielsweise mit metallischen Partikel versehen ist, die die Flüssigkeit auch im ausgehärteten Zustand elektrisch leitfähig machen, so dass mit Hilfe der Funktionsflüssigkeiten elektrische Leiterbahnen gedruckt werden können. Beispielsweise können die Eigenschaften Merkmale der elektrischen Speicherfähigkeit aufweisen.

Eine Trennschicht wird durch eine Flüssigkeit gebildet, die nach dem Aufbringen, im ausgehärteten Zustand die folgenden Merkmale im Einzelnen oder gesamt erfüllt:
- weist haftvermittelnde Eigenschaften auf
- bildet elektrisch und/oder thermisch isolierte Schichten

Eine Deckschicht wird durch eine Flüssigkeit gebildet, die nach dem Aufbringen, im ausgehärteten Zustand die folgenden Merkmale im einzelnen oder gesamt erfüllt:
- weist haftvermittelnde Eigenschaften auf
- bildet elektrisch und/oder thermisch isolierte Schichten
- bildet chemisch und mechanisch eine widerstandsfähige Deckschicht

Eine Möglichkeit zur Dekorierung der Oberflächen der obersten Schichtlage ist dadurch gegeben, dass eine Dekorschicht oder Farbschicht z.B. mittels Digitaldruck (52) mit entsprechenden Haftungseigenschaften aufgebracht wird.
Zur Haftungserhöhung kann hierbei zusätzlich eine Haftvermittlungsschicht und eine weitere widerstandsfähige Schicht als Deckschicht auf die Dekorschicht aufgebracht werden.

Figur 1/a zeigt ein Substrat (40) mit einer aufgebrachten Funktionsschicht (10). Mittels einer Steuereinrichtung (50) werden Flüssigkeitströpfchen durch Drucköpfe (54) über eine Aufbringeinrichtung (52) zur Bildung einer Deckschicht (26) abgegeben.
Die Flugbahn der Flüssigkeitströpfchen erfolgt im ca. 90 Grad Winkel zum Substrat (40). Wird ein überlagernder Schichtbereich mit einer konstanten Auftragsmenge (26) in einer größeren geometrischen Abmessung auf einen darunterliegenden Schichtbereich (10) aufgebracht, erfolgt ein Schichtversatz (Schichtabbruch). Der Schichtversatz wird durch die Schichtdicke der darunter liegenden Schicht (10) bestimmt.
Hat beispielsweise die darüberliegende Deckschicht (26) die Funktion eines Isolators, entsteht in der Isolatorschicht ein technischer Mangel.
Hat beispielsweise die darüberliegende Funktionsschicht (12) die Funktion eines Leiters, entsteht ein veränderter Leitquerschnitt oder eine Unterbrechung der Leitfähigkeit.

Figur 1/b zeigt einen Querschnitt durch einen Schichtaufbau wobei auf ein Substrat (40) eine Trennschicht (20), die gleichzeitig isolierende und haftvermittelnde Eigenschaften aufweist, in einer geometrischen Abmessung sowie Schichtdicke aufgebracht ist.

Auf der Trennschicht (20) ist mittels Ink-Jet Druckverfahrens (50, 52, 54) eine geometrische Abmessung in definierter Schichtdicke eine Funktionsschicht (10) aufgebracht. Darüberliegend ist mit einer vergrößerten geometrischen Abmessung eine Deckschicht (26) aufgebracht, die gleichzeitig die Eigenschaften eines Isolators aufweist.
Über das Steuerungsprogramm (50) wird in dem überlagernden Schichtbereich (26) eine Volumenzugabe zur Bildung eines volumenbildenden Schichtbereichs (30) ausgebildet. Vorteilhaft ist es den Schichtbildungszuwachs (30) um das Volumen der Schichthöhe der darunterliegenden Schicht (10) zu erhöhen.
Die Steuerung ist in einer Anwendungsform so ausgelegt, dass eine relativ konstante Schichtdicke (26, 30) über den Kantenbereich der darunterliegenden Schicht (10) hergestellt wird. Der randbildende Schichtbereich der Deckschicht (26) bildet mit der Trennschicht (20) eine feste Verbindung.
In einer nichtgezeigten Ausführungsform kann auf eine Trennschicht / Isolatorschicht (10) verzichtet werden. Gegeben ist diese Ausführungsform, wenn technische Erfordernisse an Haftung oder Leitfähigkeit der Materialkombinationen erfüllt sind.
Die Deckschicht (26) bildet in dieser Ausführungsform über den Kantenbereich der Funktionsschicht (10) eine konstante Schichtdicke und bildet zum Substrat (40) eine geschlossene Verbindung.

Figur 1/c zeigt einen Querschnitt durch einen Schichtaufbau wobei auf ein Substrat (40) eine Funktionsschicht (10) in einer geometrischen Abmessung sowie Schichtdicke aufgebracht ist.
Die darüberliegende Trennschicht (20) mit Isolatorfunktion weist eine verkleinerte geometrische Abmessung sowie definierte Schichtdicke auf.

Wie unter 1/b beschrieben bildet die Funktionsschicht 2 (12) um den Kantenbereich der darunter angeordneten Trennschicht (20) durch Volumenerweiterung (32) eine konstante, leitfähige Schichtdicke (Querschnitt) und eine Verbindung zu Funktionsschicht (10).

Figur 2 zeigt Substrate (40) in Form von Flächen oder Körpern bei denen das Verfahren anwendbar ist. Das Verfahren kann auf ebenen und gewölbten Oberflächen oder auf Körpern oder Körperwänden innen und/oder aussenseitig, umlaufend (3D) angewand werden.

Figur 3 zeigt Ausführungsformen von Vorrichtungen zum Beschichten eines Subtrates mit aushärtbaren Flüssigkeiten mit einer Aufbringeinrichtung, einer Halterung zum Halten oder Führen einer Fläche (40) oder eines Bauteils (40), einer Bewegungseinrichtung mittels der die Oberfläche des Substrates (40) relativ zu der Aufbringeinrichtung (52) bewegbar ist, sowie eine Härteeinrichtung und eine Messeinrichtung.
Die Aufbringeinrichtung (52) enthält einen oder mehrere Düsenköpfe mit Flüssigkeitsdüsen, aus denen Flüssigkeitströpfchen (54)mit vorbestimmtem Volumen und Vorschub abspritzbar sind. Der oder die Düsenköpfe sind mit Flüssigkeitsvorratsbehältern verbunden aus denen den Düsenköpfen bzw. deren Düsen unterschiedliche Substanzen (54) für Funktionsschichten (10 - 15), Haftvermittlungsschicht (20-24), Deckschichten (26) und Dekorschicht zugeführt werden können.
Der oder die Düsenköpfe (52) sind mittels eines nicht dargestellten Antriebs in z-Richtung vertikal und γ-Richtung senkrecht zum Substrat bewegbar, so dass der oder die Düsenköpfe (52) relativ zu einer auf dem Endlosband aufliegenden Fläche oder einem Körper beliebig bewegbar sind und aus dem oder den Düsenköpfen (52) Flüssigkeitströpfchen in genau vorbestimmter Weise auf vorbestimmte Stellen des Subtrates (40) aufgebracht werden.
Zur Positionsbestimmung des oder der Düsenköpfe (52) relativ zur Substratoberfläche kann in den oder die Düsenköpfe (52) eine nicht dargestellte Sensoreinrichtung integriert sein mit der einerseits die Position einer Düse relativ zur Substratoberfläche und anderseits die Position einer Düse relativ zur Substratoberfläche (40) in x-, y- und z-Richtung und beliebigen Neigungswinkeln bestimmt werden kann.
Zur Steuerung der Aufbringeinrichtung bzw. des Abspritzens der Flüssigkeitströpfchen und der Relativbewegung zwischen den Düsen und den Oberflächen ist die in ihrem Aufbau an sich bekannte elektronische Steuerung (50) vorgesehen, die in unterschiedlichster Weise programmiert sein kann.
Beispielsweise können in der elektronischen Steuereinrichtung (50) die Kontur der Körperoberfläche, deren Erstreckung in x-,y-,z- Richtung, Eigenschaften der aufzubringenden Flüssigkeit(en), differenzierte Mengensteuerung der aufzubringenden Flüssigkeiten auf Positionen einer Flächeneinheit der Körperfläche, Relativbewegung zwischen dem Düsenkopf (52) und der Körperoberfläche (40) usw. abgelegt sein.

Figur 4 zeigt einen Querschnitt durch Ausbildungsformen von Funktionsschichten (10) auf einem Substrat (40). In einem Steuerprogramm (50) können diese Querschnittanforderungen nach Geometrieformen und Leitfähigkeit abrufbar gespeichert sein.

Die geometrische Form einer Funktionsschicht mit Energiespeichereigenschaften läßt sich so beispielsweise in einer flachen Ausführungsform auf eine gewölbte Substratoberfläche (40) aufbringen.

Figuren 5/a,b zeigen einen Querschnitt durch einen Schichtaufbau wobei auf einem Substrat (40) zwei geometrische Abmessungen einer Funktionsschicht (10) auf eine Trennschicht (20) aufgebracht sind.
Über das Steuerungsprogramm (50) wird in die geometrische Form der überlagernden Deckschicht (26) durch Volumenzugabe ein volumenbildender Schichtbereich (30) ausgebildet. Die Volumenzugabe wird nach der geometrischen Form der Zwischenschicht der Funktionsschichten (10) und deren Schichtdicke berechnet.
Zwischen Deckschicht (26) und Trennschicht (20) entsteht eine feste Verbindung.

Figuren 6/a,b zeigen einen Querschnitt durch einen mehrlagigen Schichtaufbau auf einem Substrat (40).
Trennschicht 2 (22) mit einem volumenbildenden Schichtbereich (30), bildet mit Trennschicht (20) eine geschlossene Isolationsschicht mit relativ konstanter Schichtstärke um die Funktionsschicht 2 (12).
Über das Steuerungsprogramm (50) wird in die geometrische Form der überlagernden Funktionsschicht 3 (14) durch Volumenzugabe ein volumenbildender Schichtbereich (32) ausgebildet.
Die Funktionsschicht 3 (14) stellt über den volumenbildenden Schichtbereich (32) eine leitfähige Verbindung zur Funktionsschicht (10) her.

Figur 7/a zeigt einen Querschnitt durch einen Schichtaufbau wobei mehrere Funktionsschichten durch Trennschichten getrennt, übereinander angeordnet sind.
Die Funktionsschichten sind nach oben hin in einem Versatz angeordnet. Die geometrische Abmessung der darüber liegenden Funktionsschicht ist in einem Flächenbereich kleiner als die geometrische Abmessung der darunter liegenden Funktionsschicht. Es entsteht durch die Schichten-Stufung ein kegelförmiger Stufen-Korridor (60).
Bedingt wird diese stufenförmige Anordnung durch das digitale Druckverfahren. Die aus dem Druckkopf ausgelösten Substanzentröpfchen (54) werden durch die Druckköpfe der Aufbringeinrichtung (52) relativ senkrecht zur Substratoberfläche (40) abgegeben. Die Qualität der digital gedruckten Geometrien liegt in einem Toleranz-Distanzbereich der durch einen minimalen Abstand und einen maximalen Abstand der Drucköpfe zur Substratoberfläche je nach Druckkopftyp definiert ist. Es ist daher von Vorteil, bei der Anordnung der Schichten-Stufung (33) eine maximale Bauhöhe von 2-6 mm zu berücksichtigen.

Durch die stufenförmige Anordnung ist es möglich jede Funktionsschicht (10, 12, 14) mit einer darüber oder darunter angeordneten anderen Funktionsschicht (10, 12, 14) durch Aufbringen von digital gesteuerten leitfähigen Substanztröpfchen zu verbinden. Gleichzeitig können auch mehrere Kontaktstellen (34) unterschiedlicher Funktionsschichten (10, 12, 14) miteinander leitfähig verbunden werden.
Die geometrische Abmessung einer Trennschicht die unter der geometrischen Abmessung einer Funktionsschicht angeordnet ist, ist gleich groß oder mit einer Randzugabe versehen, vergrößert.
In einer Schichtebene können eine oder mehrere leitfähige Funktionsschichtbereiche angeordnet sein.
Der Schnittstellenversatz der Schichten-Stufung (33) ist abhängig herstellbar von dem erforderlichen Querschnitt der Leitfähigkeit. Beispielsweise wird durch den gebräuchlichsten Schichten-Versatz (33) eine Kontaktfläche (34) von 1/100 mm² bis 10 mm² gebildet.

Figur 7/b zeigt eine Aufsicht auf Beispiele von Bauvarianten von Schicht-Stufungen.
Durch eine kreisförmige Vergrößerung der sich überlagernden Schichtbereiche entsteht ein kegelförmiger Stufen-Korridor (60). Eine geringere Anzahl leitfähiger Schnittstellen können durch einen Stufen-Korridor (62) vorteilhaft verbunden werden.

Figuren 8/a,b zeigen einen Querschnitt durch eine Schichten-Stufung (33) wobei verschiedene Kombinationen von Bauvarianten dargestellt sind.
Über den volumenbildenden Schichtbereich (32) der Funktionsschicht (14) findet eine leitfähige Verbindung mit den in Schicht-Stufen (33) angeordneten, darunter liegenden Funktionsschichten (12 und 10) statt.
Der Funktionsschichtbereich (15) wird von einer kapselbildenden Trennschicht eingeschlossen, die durch die darüberliegende Trennschicht (24) mit dem volumenbildenden Schichtbereich (30) und der darunterliegenden Trennschicht (22) gebildet wird.

Figur 9 zeigt einen Querschnitt eines auf einem Substrat (40) angeordneten Elektro,- Elektronikbauteil (70). Durch die nach oben gerichtete Zugabe eines volumenbildenden Schichtbereichs (32) in der Funktionsschicht (10) erfolgt eine Kontaktierung mit einem konstanten Leistungsquerschnitt mit der erhöhten Kontaktstelle (72) des Elektro,- Elektronikbauteils (70).

Figur 10/a zeigt einen Querschnitt auf ein Bauteil, das aus sich überlagernden Funktionsschichtbereichen und Trennschichten aufgebaut ist wobei die Funktionsschichten über einen Schnittstellen-Stufen-Korridor (62) teilweise verbunden sind.
Die Deckschichtmantelung (26) bildet mit einer Zugabe des volumenbildenen Schichtbereiches (30), mit den Trennschichten (22) und (24) und dem Substrat (40) eine Bauteilekapselung. Auf diese Weise lassen sich beispielsweise wasserfeste, biegefähige und /oder elastisch verformbare Elektro,-Elektronikbauteile herstellen.

In der Zeichnung nicht dargestellt, lässt sich über eine integrierte Steck,- Kontaktverbindung das Bauteil weiter vernetzen.
Desweiteren können funktionserweiternde Elektro,- Elektronikmodule (70) in der Kapselung eingeschlossen werden.
Erfindungsgemäß ist es hiermit möglich, wasserfeste und stoßsichere Schaltungen, Schaltkreise oder Leiterbahnen die aus sich überlagernden Funktionsschichten bestehen auf einem Substrat (40) herzustellen.

Figur 10/b zeigt einen Querschnitt auf ein Bauteil baugleich wie FIG 10/a, wobei die sich überlagernden Schichtbereiche und das Substrat (40) biegefähige,- und /oder elastische Eigenschaften aufweisen.

Figur 11 zeigt einen Querschnitt eines Substrates (40) mit sich überlagernder Schichten. Gezeigt wird in dieser Ausführungsform eine Variante einer konstanten Randbildung zu FIG 1/b und FIG 1/c.
Um eine relativ konstante Randstärke in der Deckschicht (26) herzustellen wird im Randbereich der darunterliegenden Trennschicht (10) über die Steuereinrichtung (50) eine Verringerung der Auftragsmenge vorgenommen. Im Steuerprogramm lassen sich unterschiedliche Auslaufkurven für einen volumenreduzierten Schichtbereich (35) hinterlegen.

### Bezugszeichenliste

- 10: Funktionsschicht
- 12: Funktionsschicht 2
- 14: Funktionsschicht 3
- 15: Funktionsschicht 4
- 20: Trennschicht
- 22: Trennschicht 2
- 24: Trennschicht 3
- 26: Deckschicht-Mantelung
- 30: Volumenbildender Schichtbereich /Trennschicht
- 32: Volumenbildender Schichtbereich / Funktionsschicht
- 33: Schichten-Stufung
- 34: Kontaktfläche
- 35: Volumenreduzierter Schichtbereich
- 40: Substrat
- 50: Steuereinrichtung
- 52: Aufbringeinrichtung / Druckkopf
- 54: Substanzen
- 57: Anlagenkonfiguration 1
- 58: Anlagenkonfiguration 2
- 59: Anlagenkonfiguration 3
- 60: Kegelförmiger Stufen-Korridor
- 62: Schnittstellen Stufen-Korridor
- 70: Elektro,- Elektronikmodul
- 72: Kontaktstelle

## Patentansprüche

1. Verfahren zum Herstellen von elektrischen,- elektronischen Funktionen auf einem Substrat wobei,
- Funktionsschichten und zumindest eine Trennschicht überlagernd angeordnet sind,
- die geometrische Abmessung einer Trennschicht funktionsbezogen der geometrischen Abmessung einer Funktionsschicht zugeordnet ist,
- stufenförmige angeordnete Kontaktflächen (34) der sich überlagernden Funktionsschichten gebildet werden, indem jeweils in den der Funktionsschicht überlagernden Schichtbereichen eine Aussparung in der geometrischen Abmessung erfolgt,
- und digital gesteuerte, aushärtbare Flüssigkeitströpfchen (30) zur Bildung einer leitfähigen Funktionsschicht volumenbildend so aufgebracht werden, dass zumindest zwischen zwei Funktionsschichten aus unterschiedlichen Schichtbereichen eine leitfähige Verbindung gebildet wird.

2. Verfahren nach Anspruch 1, die gebildeten Kontaktstellen (34) der Funktionsschichten, nach oben terassenförmig (33), (60) angeordnet sind.

3. Verfahren nach einem der Ansprüche 1 bis 2, die geometrischen Abmessungen der übereinander angeordneten Schichtbereiche aus aushärtbaren Flüssigkeitströpfchen mittels einem Ink-Jet Druckverfahren elektronisch gesteuert aufgebracht werden.

4. Verfahren nach einem der Ansprüche 1 bis 3, wobei beim Auftragen der Flüssigkeitströpfchen (54) zur Herstellung einer geometrischen Abmessung eines Schichtbereiches die Abgabe der Auftragsvolumen positionsbezogen (30), (32), (35) regelbar sind.

5. Verfahren nach einem der Ansprüche 1 bis 4, wobei eine Funktionsschicht(12) einen leitfähigen, volumenbildenden Randbereich (32) über eine Trennschicht (22) zu einer untenliegenden Funktionsschicht (10) bildet.

6. Verfahren nach einem der Ansprüche 1 bis 5, wobei eine Trennschicht (22) einen isolierenden, volumenbildenden Randbereich (30), über eine Funktionsschicht (10) zu einer untenliegenden Trennschicht (20) bildet.

7. Verfahren nach einem der Ansprüche 1 bis 6, wobei eine Deckschicht (26) mit dem Substrat (40) eine wasserfeste, formumgebende Kapselung bildet und eine Kontaktstelle zu einer Funktionsschicht (10) mit Bestandteil sein kann.

8. Verfahren nach einem der Ansprüche 1 bis 7, wobei das Substrat (40) eine mit nach dem Verfahren beschichtete Oberfläche aufweist, biegefähig und/oder elastisch ist.

9. Verfahren nach einem der Ansprüche 1 bis 8, wobei auf einem Substrat (40) eine Funktionsschicht (10) eine Kontaktstelle (72) zu einem Elektro,-Elekronikmodul (70) mit einem volumenbildenden Schichtbereich (32) bildet.

10. Verfahren nach einem der Ansprüche 1 bis 9, wobei die geometrischen Flächen der überlagernden Schichtbereiche auf die geometrische Abmessungen (40) von gewölbten Flächen oder Körpern angeglichen sind und mittels einem digitalem Druckverfahren 3d (57), (58), (59) aufgebracht werden.

11. Bauteil mit einem Grundkörper, der eine entsprechend einem Verfahren nach einem der Ansprüche 1 bis 10 beschichtete Oberfläche aufweist.
